# EUROPEAN PATENT SPECIFICATION

(11) **EP 1 736 572 B1**
(45) Date of publication and mention of the grant of the patent: **20.06.2012**
(21) Application number: 05721657.4
(22) Date of filing: 30.03.2005
(51) Int. Cl.: C30B 29/40

(54) **GROUP III NITRIDE CRYSTAL SUBSTRATE, METHOD FOR PRODUCING SAME, AND GROUP III NITRIDE SEMICONDUCTOR DEVICE**
GRUPPE-III-NITRID-KRISTALLSUBSTRAT, HERSTELLUNGSVERFAHREN DAFÜR UND GRUPPE-III-NITRID-HALBLEITERELEMENT
SUBSTRAT DE CRISTAL DE NITRURE DE GROUPE III, PROCEDE DE FABRICATION DUDIT ET DISPOSITIF SEMI-CONDUCTEUR DE NITRURE DE GROUPE III

(30) Priority: 12.04.2004 JP 2004116879
(43) Date of publication of application: 27.12.2006
(73) Proprietor: Sumitomo Electric Industries, Ltd., Osaka-shi, Osaka 541-0041 (JP); Mori, Yusuke, Katano-shi, Osaka 576-0033 (JP)
(72) Inventor: SASAKI, Takatomo, Minoo-shi,Osaka 562-0025 (JP); MORI, Yusuke, 5760033 (JP); YOSHIMURA, Masashi, 6650035 (JP); KAWAMURA, Fumio, 5620022 (JP); HIROTA, Ryu c/o Itami Works of Sumitomo Electric Ind., Ltd., Itami-shi, Hyogo 664-8611 (JP); NAKAHATA, Seiji c/o Itami Works of Sumitomo Electric Ind., Ltd., Itami-shi, Hyogo 664-8611 (JP)
(74) Representative: Grünecker, Kinkeldey, Stockmair & Schwanhäusser
(86) International application number: PCT/JP2005/006068
(87) International publication number: WO 2005/100647

(56) References cited:
- EP-A- 1 538 241
- EP-A- 1 634 980
- JP-A- 2003 511 326
- JP-A- 2004 277 224
- JP-A- 2005 008 444
- JP-A- 2005 112 718
- JP-A- 2005 154 254
- US-A1- 2003 164 138
- AOKI M ET AL: "Conditions for seeded growth of GaN crystals by the Na flux method" MATERIALS LETTERS, NORTH HOLLAND PUBLISHING COMPANY. AMSTERDAM, NL, vol. 56, no. 5, 1 November 2002 (2002-11-01), pages 660-664, XP004388914 ISSN: 0167-577X
- SLACK G A ET AL: "Growth of high purity AlN crystals" JOURNAL OF CRYSTAL GROWTH, ELSEVIER, AMSTERDAM, NL, vol. 34, no. 2, 1 July 1976 (1976-07-01), pages 263-279, XP022624365 ISSN: 0022-0248 [retrieved on 1976-07-01]
- BALKAS C M ET AL: "Growth and characterization of GaN single crystals" JOURNAL OF CRYSTAL GROWTH, ELSEVIER, AMSTERDAM, NL, vol. 208, no. 1-4, 1 January 2000 (2000-01-01), pages 100-106, XP004253381 ISSN: 0022-0248

## Description

### Technical Field

The present invention relates to a group III-nitride crystal substrate obtained by growing group III-nitride crystal from a melt containing an alkali metal element, a group III-element and a nitrogen element and a manufacturing method thereof, as well as to a group III-nitride semiconductor device in which at least one group III-nitride crystal layer is formed on the group III-nitride crystal substrate.

### Background Art

A sapphire substrate, a GaN substrate or the like is used as a substrate for a semiconductor device such as a light emitting diode (hereinafter referred to as LED) or a laser diode (hereinafter referred to as LD).

As the sapphire substrate attains high insulation, it is not possible to provide an electrode on a back surface of the sapphire substrate (referring to a surface of the substrate where a semiconductor layer having a light emission layer is not formed, hereinafter the same as above). Therefore, not only a p-side electrode but also an n-side electrode should be formed on the semiconductor layer which is formed on the sapphire substrate. In such a case, as a result of a current passing through the semiconductor layer having a small thickness, a drive voltage of a light emission device has undesirably been high.

In contrast, since the GaN substrate may be provided with an electrode also on its back surface, the drive voltage of the light emission device can be lowered. Meanwhile, an absorption coefficient of the GaN substrate is larger than that in the sapphire substrate, and a part of light emission is absorbed in the GaN substrate in an LED or the like, which results in lower light emission intensity. In order to solve this problem, a method of manufacturing a GaN crystal substrate attaining high transparency and a low absorption coefficient by using vapor phase growth such as HVPE (Hydride Vapor Phase Epitaxy) as well as a GaN crystal substrate obtained through that manufacturing method have been proposed. The absorption coefficient of that GaN crystal substrate, however, is not sufficiently small (see, for example, Japanese Patent Laying-Open No. 2000-12900 (Patent Document 1)).

Meanwhile, a method of manufacturing a GaN crystal substrate by using a flux method in which GaN crystal is grown from a melt containing Na representing an alkali metal element, Ga representing a group III-element, and a nitrogen element N has also been proposed. The GaN crystal substrate obtained through the flux method, however, is also colored orange or brown, and the absorption coefficient of that GaN crystal substrate is not sufficiently small (see, for example, Hisanori Yamane, et al., "GaN Single Crystal Growth by the Flux Method," Oyo Buturi, The Japan Society of Applied Physics, May, 2002, Vol. 71, No. 5, pp.548-552 (Non-Patent Document 1)).

Therefore, development of a GaN crystal substrate attaining a low absorption coefficient, which will serve as a substrate for a semiconductor device such as an LED or an LD, has been desired.
Patent Document 1: Japanese Patent Laying-Open No. 2000-12900
Non-Patent Document 1: Hisanori Yamane, et al., "GaN Single Crystal Growth by the Flux Method," Oyo Buturi, The Japan Society of Applied Physics, May, 2002, Vol. 71, No.5, pp.548-552

EP-A-1 634 980 is a prior art document according to Article 54 (3) EPC. This document discloses a method for manufacturing a group III-nitride (GaN) crystal substrate from a melt containing sodium, gallium and nitrogen inside a reactor. The growth temperature is set to 890 degrees C.

EP-A-1 538 241 is a prior art document according to Article 54 (3) EPC. This document discloses a method for manufacturing a group III-nitride (GaN) crystal substrate from a melt containing sodium, gallium and nitrogen inside a reactor. The growth temperature is set to 880 degrees C.

Aoki M. et al discloses in the paper "Conditions for seeded growth of GaN crystals by the Na flux method," published in Materials Letters, North Holland Publishing Company, Amsterdam, NL, vol. 56, no 5, 1 November 2002, on pages 660-664, a method for manufacturing a group III-nitride (GaN) crystal substrate from a melt containing sodium, gallium and nitrogen inside a reactor. The growth temperature is set to 850 degree C.

US 2003/164138 A1 teaches a method for manufacturing a group III-nitride (GaN) crystal substrate from a melt containing sodium, gallium and nitrogen inside a reactor. The growth temperature can be 1000 degree C and is, in a specific example, set to 850 degree C.

Balkas C. et al discloses in the paper " Growth and characterization of GaN. Single crystals," published in Journal of Crystal Growth Vol. 208, 2000 on pages 100-106 a sublimation growth method for producing GaN Single Crystals with an oxygen impurity of 3 × 10¹⁸ cm⁻³ and an optical absorption coefficient estimated to be 50 cm⁻¹ over the wavelength range 400 - 650 nm.

### Disclosure of the Invention

### Problems to be Solved by the Invention

An object of the present invention is to provide a group III-nitride crystal substrate attaining a low absorption coefficient manufactured according to a method of manufacturing a group III-nitride crystal substrate in which group III-nitride crystal grows from a melt containing an alkali metal element, a group III-element and a nitrogen element, the manufacturing method, and a group III-nitride semiconductor device.

### Means for Solving the Problems

The problem is solved by a method of manufacturing as set forth in claim 1 and a respective substrate as set forth in claim 8. Preferred embodiments are set forth in the dependent claims.

According to one aspect of the present invention, a method of manufacturing a group III-nitride crystal substrate in which group III-nitride crystal grows from a melt containing an alkali metal element, a group III-element and a nitrogen element, includes the steps of: introducing an alkali-metal-element-containing substance containing the alkali metal element, a group III-element-containing substance containing the group III-element, and a nitrogen-element-containing substance containing the nitrogen element into a reactor; forming the melt containing at least the alkali metal element, the group III-element and the nitrogen element in the reactor; and growing the group III-nitride crystal from the melt. At least in the step of introducing the alkali-metal-element-containing substance into the reactor, the alkali-metal-element-containing substance is handled in a drying container in which a moisture concentration is controlled to at most 1.0ppm, and/or in the step of growing the group III-nitride crystal from the melt, a growth temperature of the group III-nitride crystal is set to at least 850°C.

In the method of manufacturing a group III-nitride crystal substrate according to the present invention, at least in the step of introducing the alkali-metal-element-containing substance into the reactor, the alkali-metal-element-containing substance may be handled in the drying container in which a moisture concentration is controlled to at most 0.54ppm.

In addition, in the method of manufacturing a group III-nitride crystal substrate according to the present invention, the step of introducing the alkali-metal-element-containing substance, the group III-element-containing substance and the nitrogen-element-containing substance into the reactor includes the steps of introducing the alkali-metal-element-containing substance and the group III-element-containing substance into the reactor, forming a group III-alkali melt containing at least the alkali metal element and the group III-element in the reactor, and introducing the nitrogen-containing substance into the group III-alkali melt. The step of forming the melt containing at least the alkali metal element, the group III-element and the nitrogen element in the reactor may include the step of dissolving the nitrogen-element-containing substance in the group III-alkali melt.

Moreover, in the method of manufacturing a group III-nitride crystal substrate according to the present invention, the step of growing the group III-nitride crystal from the melt may further include the step of introducing at least one of the alkali-metal-element-containing substance, the group III-element-containing substance and the nitrogen-element-containing substance into the reactor.

According to another aspect of the present invention, a group III-nitride crystal substrate manufactured with the method of manufacturing a group III-nitride crystal substrate described above attains an absorption coefficient, in a wavelength range from 400nm to 600nm, of at most 40cm⁻¹.

According to yet another aspect of the present invention, a group III-nitride crystal substrate manufactured with the method of manufacturing a group III-nitride crystal substrate described above attains an oxygen concentration of at most 1 x 10¹⁷/cm³.

According to yet another aspect of the present invention, a group III-nitride crystal substrate attains an oxygen concentration of at most 1×10¹⁷/cm³ and an absorption coefficient, in a wavelength range from 400nm to 600nm, of at most 40cm⁻¹.

According to yet another aspect of the present invention, a group III-nitride semiconductor device has at least one group III-nitride crystal layer formed on the group III-nitride crystal substrate described above.

### Effect of the Invention

As described above, according to the present invention, a group III-nitride crystal substrate attaining a small absorption coefficient and a method of manufacturing the same as well as a semiconductor device attaining high light emission intensity can thus be provided.

### Brief Description of the Drawings

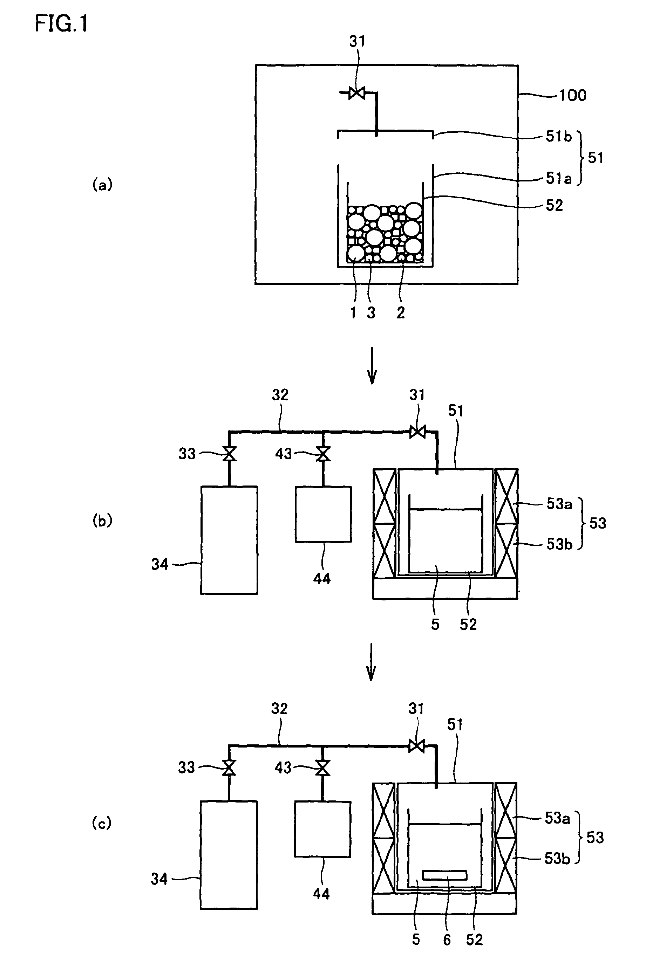

Fig. 1 is a schematic diagram of a step showing a method of manufacturing a group III-nitride crystal substrate according to the present invention; (a) shows the step of introducing an alkali-metal-containing element, a group III-element-containing substance, and a nitrogen-element-containing substance into a reactor; (b) shows the step of forming a melt containing at least the alkali metal, the group III-element and the nitrogen element; and (c) shows the step of growing group III-nitride crystal from the melt.

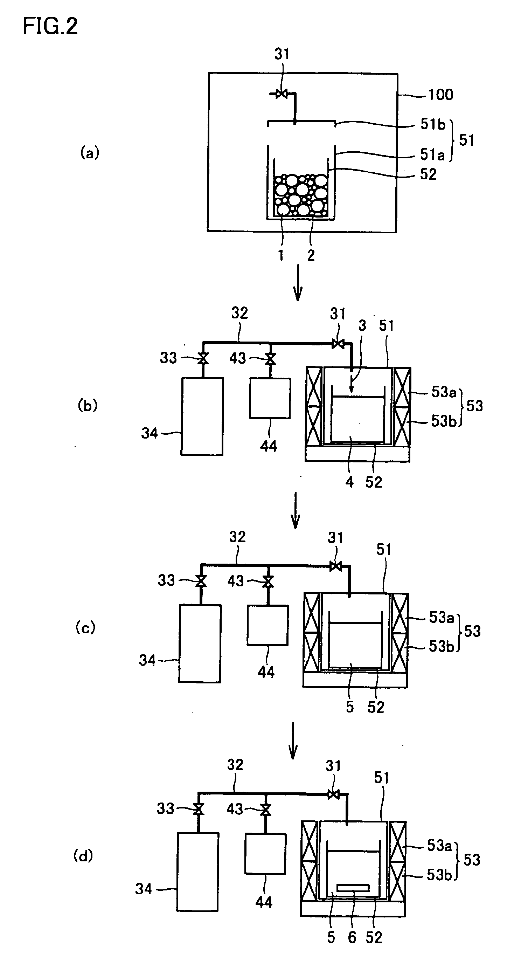

Fig. 2 is a schematic diagram of a step showing another method of manufacturing a group III-nitride crystal substrate according to the present invention; (a) shows the step of introducing an alkali-metal-containing element and a group III-element-containing substance into a reactor; (b) shows the step of further introducing the nitrogen-element-containing substance into the reactor; (c) shows the step of forming a melt containing at least the alkali metal, the group III-element and the nitrogen element; and (d) shows the step of growing group III-nitride crystal from the melt.

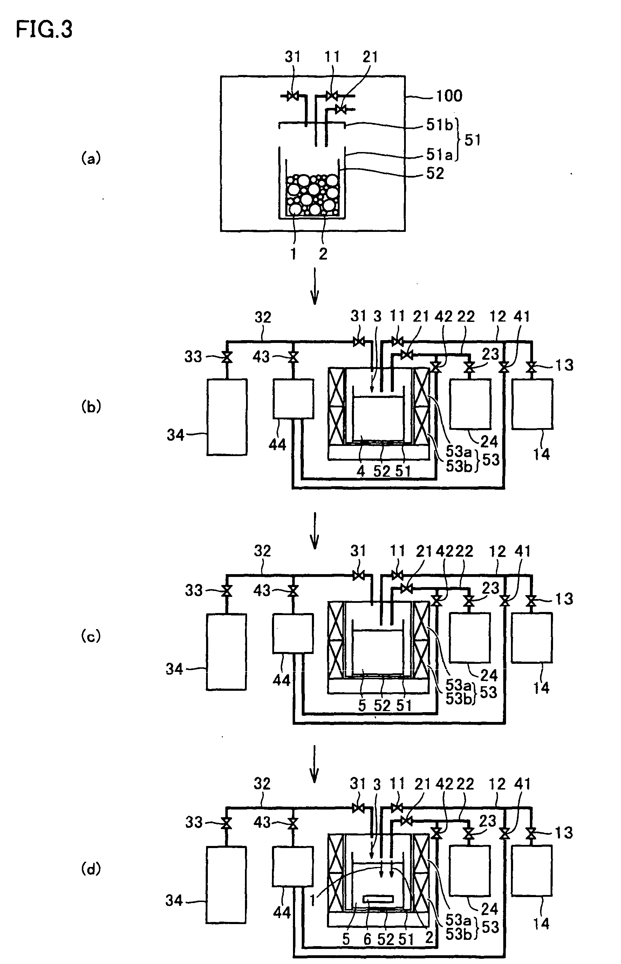

Fig. 3 is a schematic diagram of a step showing yet another method of manufacturing a group III-nitride crystal substrate according to the present invention; (a) shows the step of introducing an alkali-metal-containing element and a group III-element-containing substance into a reactor; (b) shows the step of further introducing the nitrogen-element-containing substance into the reactor; (c) shows the step of forming a melt containing at least the alkali metal, the group III-element and the nitrogen element; and (d) shows the step of growing group III-nitride crystal from the melt.

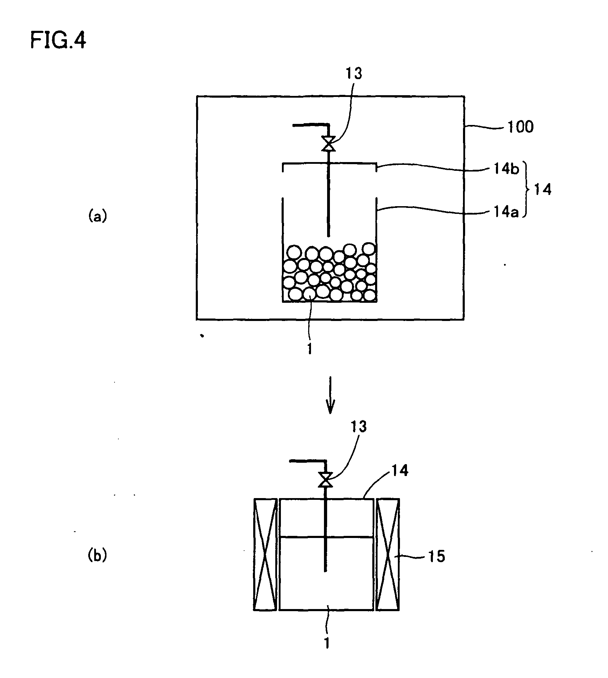

Fig. 4 is a schematic diagram of a step showing a method of introducing an alkali-metal-element-containing substance into an alkali-metal-element-containing substance supply container in the present invention; (a) shows the step of introducing the alkali-metal-element-containing substance into the alkali-metal-element-containing substance supply container; and (b) shows the step of melting the alkali-metal-element-containing substance.

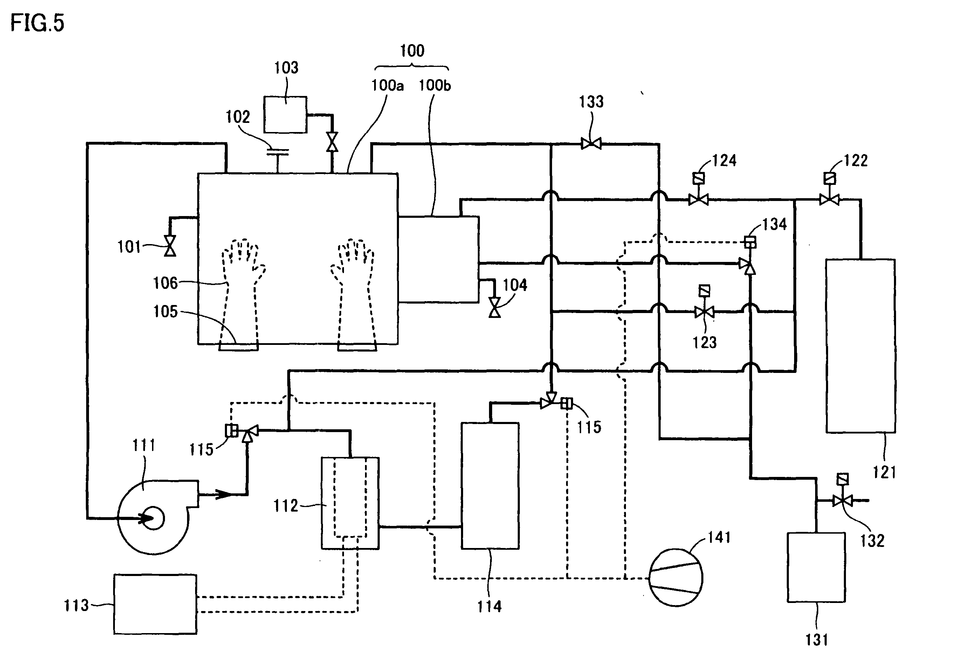

Fig. 5 is a schematic diagram of a method of controlling moisture concentration in a drying container used in the present invention.

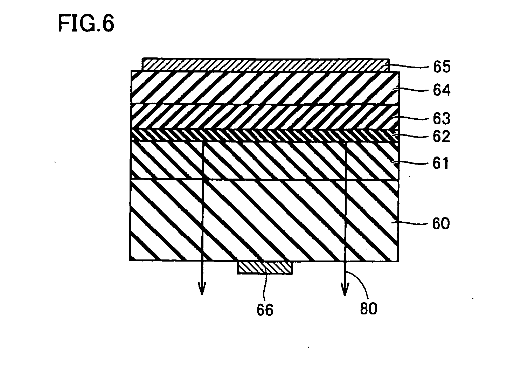

Fig. 6 is a schematic cross-sectional view of a semiconductor device according to the present invention.

### Description of the Reference Characters

1 alkali-metal-element-containing substance; 2 group III-element-containing substance; 3 nitrogen-element-containing substance; 4 group III-alkali melt; 5 melt; 6 group III-nitride crystal; 11 alkali-metal-element-containing substance introduction valve; 12 alkali-metal-element-containing substance supply line; 13 alkali-metal-element-containing substance supply valve; 14 alkali metal element supply container; 14a alkali metal element supply container main body; 14b alkali metal element supply container cover; 15, 53, 53a, 53b heater; 21 group III-element-containing substance introduction valve; 22 group III-element-containing substance supply line; 23 group III-element-containing substance supply valve; 24 group III-element-containing substance supply container; 31 nitrogen-element-containing substance introduction valve; 32 nitrogen-element-containing substance supply line; 33 nitrogen-element-containing substance supply valve; 34 nitrogen-element-containing substance supply container; 41, 42, 43 evacuation valve; 44 evacuation apparatus; 51 reactor; 51a reactor main body; 51b reactor cover; 52 crystal growth container; 60 GaN crystal substrate; 61 n-type GaN layer; 62 multiple quantum well structure; 63 p-type In_{0.20}Ga_{0.80}N layer; 64 p-type GaN layer; 65 p-side electrode; 66 n-side electrode; 80 light emission; 100 drying container; 100a main container; 100b side container; 101 main purge valve; 102 moisture meter; 103 oximeter; 104 side purge valve; 105 armhole; 106 glove; 111 blower; 112 cooling tower; 113 cooler; 114 dehydration/deoxidation tower; 115 circulation valve; 121 inert gas supply container; 122 inert gas supply source valve; 123 inert gas main supply valve; 124 inert gas side supply valve; 131 vacuum pump; 132 leakage electromagnetic valve; 133 main evacuation valve; 134 side evacuation valve; and 141 baby compressor.

### Best Modes for Carrying Out the Invention

### (Embodiment 1)

Referring to Fig. 1, a method of manufacturing a group III-nitride crystal substrate according to the present invention is directed to a method of manufacturing a group III-nitride crystal substrate in which group III-nitride crystal 6 grows from a melt 5 containing an alkali metal element, a group III-element and a nitrogen element. The method includes the steps of: introducing an alkali-metal-element-containing substance 1 containing the alkali metal element, a group III-element-containing substance 2 containing the group III-element, and a nitrogen-element-containing substance 3 containing the nitrogen element into a reactor 51 as shown in Fig. 1(a); forming melt 5 containing at least the alkali metal element, the group III-element and the nitrogen element in reactor 51 as shown in Fig. 1(b); and growing group III-nitride crystal 6 from melt 5 as shown in Fig. 1(c). At least in the step of introducing alkali-metal-element-containing substance 1 into reactor 51, alkali-metal-element-containing substance 1 is handled in a drying container 100 in which a moisture concentration is controlled to at most 1.0ppm (dew point: -76°C). By setting the moisture concentration within drying container 100 to at most 1.0ppm (dew point: -76°C), oxidation of the alkali-metal-element-containing substance is prevented and introduction of an oxygen atom into the group III-nitride crystal can be suppressed, whereby a group III-nitride crystal substrate attaining a small absorption coefficient can be obtained. From such a viewpoint, it is preferable to set the moisture concentration within drying container 100 to at most 0.54ppm (dew point: -80°C).

In order to prevent oxidation of the alkali-metal-element-containing substance, drying container 100 is filled with an inert gas such as an Ar gas or N₂ gas. Preferably, the oxygen concentration within the drying container is set to at most 5ppm. Handling of the alkali-metal-element-containing substance specifically refers to taking out a prescribed amount of the alkali-metal-element-containing substance from a storage container, followed by introduction of the same into the reactor.

The alkali-metal-element-containing substance, the group III-element-containing substance and the nitrogen-element-containing substance may be in any form of gas, liquid and solid, and how and when they are introduced into the reactor may be different among one another. An example of the alkali-metal-element-containing substance includes an alkali metal such as metal Na, an alkali metal element compound such as NaN₃, and the like. An example of the group III-element-containing substance includes a group III-element metal such as metal Ga, metal AI and metal In, a group III-element compound such as GaN and GaAs, and the like. An example of the nitrogen-element-containing substance includes not only N₂ gas but also a nitrogen compound such as NH₃ gas, NaN₃ and the like.

Referring to Fig. 1, the present embodiment will further specifically be described. Initially, as shown in Fig. 1(a), in the step of introducing alkali-metal-element-containing substance 1, group III-element-containing substance 2 and nitrogen-element-containing substance 3 into reactor 51, reactor 51 is accommodated in drying container 100 in which a moisture concentration is controlled to at most 1.0ppm (dew point: -76°C) and preferably to at most 0.54ppm (dew point: -80°C). Thereafter, a reactor cover 51b is detached from a reactor main body 51a, and a prescribed amount of each of alkali-metal-element-containing substance 1 such as metal Na, group III-element-containing substance 2 such as metal Ga, and nitrogen-element-containing substance 3 such as NaN₃ or GaN is accommodated in a crystal growth container 52 provided within reactor main body 51a. Reactor main body 51a is sealed by reactor cover 51 b, and taken out of the drying container. As alkali-metal-element-containing substance 1 is handled within drying container 100 in which the moisture concentration is controlled to at most 1.0ppm (dew point: -76°C), it is not oxidized.

As shown in Fig. 1(b), in the step of forming melt 5 containing at least the alkali metal element, the group III-element and the nitrogen element in reactor 51, a nitrogen-element-containing substance introduction valve 31 of reactor 51 is connected to a nitrogen-element-containing substance supply line 32, and a heater 53 is disposed around reactor 51. An inert gas within reactor 51 is removed through an evacuation valve 43 by means of an evacuation apparatus 44 such as a vacuum pump, and thereafter, nitrogen-element-containing substance introduction valve 31 is opened to introduce N₂ gas into reactor 51. Then, reactor 51 is heated by heater 53. In this manner, the alkali-metal-element-containing substance, the group III-element-containing substance and the nitrogen-containing substance are melted to form melt 5 containing the alkali metal element (such as Na), the group III-element (such as Ga) and the nitrogen element (N). As the alkali-metal-containing substance is not oxidized, the oxygen concentration in melt 5 is low.

As shown in Fig. 1(c), a prescribed pressure and temperature of reactor 51 are set by controlling thermal output of heater 53, so as to grow GaN crystal representing group III-nitride crystal 6 from melt 5. As the oxygen concentration in melt 5 is low, the oxygen concentration of obtained group III-nitride crystal 6 is also low.

In growing group III-nitride crystal 6 from melt 5, from the viewpoint of promoted growth of group III-nitride crystal 6, the temperature of group III-nitride crystal 6 is preferably lower than the temperature of melt 5 or the nitrogen-containing substance that remains without being dissolved in the melt. For example, by controlling thermal output of a heater 53a and thermal output of a heater 53b, the temperature of the nitrogen-containing substance or melt 5 can be set higher than the temperature of group III-nitride crystal 6. In addition, though not shown, from the viewpoint of promoted growth of the group III-nitride crystal, preferably, seed crystal is introduced in advance into the reactor along with the alkali-metal-element-containing substance, the group III-element-containing substance and the nitrogen-element-containing substance such that the seed crystal is present in the melt while the group III-nitride crystal grows. Though the seed crystal is not particularly limited, group III-nitride crystal of the same type as the group III-nitride crystal that desirably grows is preferable.

The group III-nitride crystal that has grown is taken out of reactor 51 and cut to a prescribed size, and has its surface polished. The group III-nitride crystal substrate attaining low oxygen concentration and small absorption coefficient is thus obtained.

### (Embodiment 2)

According to the present embodiment, the step of introducing the alkali-metal-element-containing substance, the group III-element-containing substance and the nitrogen-element-containing substance into the reactor is implemented by the steps of introducing the alkali-metal-element-containing substance and the group III-element-containing substance into the reactor, forming the group III-alkali melt containing at least the alkali metal element and the group III-element in the reactor, and introducing the nitrogen-containing substance into the group III-alkali melt, and the step of forming the melt containing at least the alkali metal element, the group III-elemem and the nitrogen element in the reactor is implemented by the step of dissolving the nitrogen-element-containing substance in the group III-alkali melt.

Referring to Fig. 2, the present embodiment will specifically be described. Initially, the step of introducing alkali-metal-element-containing substance 1, group III-element-containing substance 2 and nitrogen-element-containing substance 3 into reactor 51 will be described. First, as shown in Fig. 2(a), reactor 51 having at least nitrogen-element-containing substance introduction valve 31 is accommodated in drying container 100 in which a moisture concentration is controlled to at most 1.0ppm (dew point: -76°C) and preferably to at most 0.54ppm (dew point:-80°C). Thereafter, reactor cover 51b is detached from reactor main body 51a, and a prescribed amount of each of alkali-metal-element-containing substance 1 such as metal Na and group III-element-containing substance 2 such as metal Ga is accommodated in crystal growth container 52 provided within reactor main body 51a. Reactor main body 51a is sealed by reactor cover 51b, and taken out of the drying container. As alkali-metal-element-containing substance 1 is handled within drying container 100 in which the moisture concentration is controlled to at most 1.0ppm (dew point: -76°C), it is not oxidized.

As shown in Fig. 2(b), nitrogen-element-containing substance introduction valve 31 of reactor 51 is connected to nitrogen-element-containing substance supply line 32, and heater 53 is disposed around reactor 51. An inert gas within reactor 51 is removed through evacuation valve 43 by means of evacuation apparatus 44 such as a vacuum pump, and thereafter, a nitrogen-element-containing substance supply container 34 is used to introduce N₂ gas into reactor 51 through nitrogen-element-containing substance introduction valve 31. Then, reactor 51 is heated by heater 53, so as to melt alkali-metal-element-containing substance 1 and group III-element-containing substance 2, thereby forming group III-alkali melt 4 containing the alkali metal element (such as Na) and the group III-element (such as Ga). As the alkali-metal-containing substance is prevented from oxidation, the oxygen concentration in group III-alkali melt 4 is low. Then, nitrogen-element-containing substance supply container 34 is used to introduce again nitrogen-element-containing substance 3 such as N₂ gas into reactor 51 through nitrogen-element-containing substance introduction valve 31, so as to adjust the pressure within reactor 51.

As shown in Figs. 2(b) and 2(c), N₂ gas representing nitrogen-element-containing substance 3 that has been introduced into reactor 51 is dissolved in group III-alkali melt 4, to form melt 5 containing the alkali metal element (such as Na), the group III-element (such as Ga) and the nitrogen element (N). As the oxygen concentration in group III-alkali melt 4 is low, the oxygen concentration in melt 5 is also low.

As shown in Fig. 2(d), a prescribed pressure and temperature of reactor 51 are set by controlling thermal output of heater 53 and by regulating nitrogen-element-containing substance introduction valve 31, nitrogen-element-containing substance supply valve 33 and evacuation valve 43, so as to grow GaN crystal representing group III-nitride crystal 6 from melt 5. As the oxygen concentration in melt 5 is low, the oxygen concentration of obtained group III-nitride crystal 6 is also low.

In growing group III-nitride crystal 6 from melt 5, from the viewpoint of promoted growth of group III-nitride crystal 6, such temperature gradient that a liquid temperature decreases from the surface of melt 5 toward the surface of group III-nitride crystal 6 is preferably set. In addition, though not shown, from the viewpoint of promoted growth of the group III-nitride crystal, preferably, seed crystal is introduced in advance into the reactor along with the alkali-metal-element-containing substance and the group III-element-containing substance such that the seed crystal is present in the melt while the group III-nitride crystal grows. Though the seed crystal is not particularly limited, group III-nitride crystal of the same type as the group III-nitride crystal that desirably grows is preferable.

The group III-nitride crystal that has grown is taken out of reactor 51 and cut to a prescribed size, and has its surface polished. The group III-nitride crystal substrate attaining low oxygen concentration and small absorption coefficient is thus obtained.

### (Embodiment 3)

According to the present embodiment, though it is not necessary to handle the alkali-metal-element-containing substance in the drying container in which a moisture concentration is controlled to at most 1.0ppm (dew point: -76°C) and preferably to at most 0.54ppm (dew point: -80°C) in the step of introducing the alkali-metal-element-containing substance into the reactor in Embodiment 1 or Embodiment 2, a growth temperature of the group III-nitride crystal is set to at least 850°C at least in the step of growing group III-nitride crystal 6 (such as GaN crystal) from melt 5 containing the alkali metal element (such as Na), the group III-element (such as Ga) and the nitrogen element (N).

That is, in Fig. 1(c) or Fig. 2(d), the crystal growth temperature in growing group III-nitride crystal 6 from melt 5 (the temperature of a growing portion of group III-nitride crystal 6, that is, the temperature corresponding to that at an interface between melt 5 and group III-nitride crystal 6 that grows) is set to at least 850°C.

As the growth temperature of the group III-nitride crystal is higher, a rate of oxygen atom taken into the crystal becomes lower and the concentration of oxygen contained in the group III-nitride crystal (such as GaN crystal) becomes lower. This may be because, as the growth temperature of the crystal is higher, each atom tends to be arranged in a more thermodynamically stable state and taking-in of the oxygen atom different in atomic radius from a group III-element atom and a nitrogen atom becomes less likely. Accordingly, the growth temperature of the group III-nitride crystal is set preferably to at least 880°C and more preferably to at least 910°C. Therefore, the group III-nitride crystal substrate obtained by cutting and polishing the group III-nitride crystal attains low oxygen concentration and small absorption coefficient.

### (Embodiment 4)

According to the present embodiment, in the step of growing group III-nitride crystal 6 (such as GaN crystal) from melt 5 containing the alkali metal element (such as Na), the group III-element (such as Ga) and the nitrogen element (N) in Embodiment 1 or Embodiment 2, a growth temperature of the group III-nitride crystal is set to at least 850°C.

Referring to Figs. 1 and 2, at least in the step of introducing alkali-metal-element-containing substance 1 into reactor 51 as shown in Fig. 1(a) or Fig. 2(a), alkali-metal-element-containing substance 1 is handled in drying container 100 in which a moisture concentration is controlled to at most 1.0ppm (dew point: -76°C) and preferably to at most 0.54ppm (dew point: -80°C), and in the step of growing group III-nitride crystal 6 from melt 5 as shown in Fig. 1(c) or Fig. 2(d), the growth temperature of group III-nitride crystal 6 is set to at least 850°C. In the present embodiment, introduction of oxygen atom into the melt and hence introduction of oxygen atom into the group III-nitride crystal is suppressed, so that the oxygen concentration in the group III-nitride crystal substrate can further be lowered.

### (Embodiment 5)

According to the present embodiment, at least the step of growing the group III-nitride crystal from the melt containing the alkali metal element, the group III-element and the nitrogen element in any one of Embodiments 1 to 4 includes the step of introducing at least one of the alkali-metal-element-containing substance, the group III-element-containing substance and the nitrogen-element-containing substance into the reactor.

Referring to Fig. 3, application of the present embodiment in Embodiment 2 will be described. Initially, as shown in Fig. 3(a), a prescribed amount of each of alkali-metal-element-containing substance 1 such as metal Na and group III-element-containing substance 2 such as metal Ga is accommodated in crystal growth container 52 provided within reactor main body 51a in drying container 100 in which a moisture concentration is controlled to at most 1.0ppm (dew point: -76°C) and preferably to at most 0.54ppm (dew point: -80°C). Reactor main body 51a is sealed by reactor cover 51b, and taken out of drying container 100. Reactor 51 employed in the present embodiment is provided with an alkali-metal-element-containing substance introduction valve 11, a group III-element-containing substance introduction valve 21, and nitrogen-element-containing substance introduction valve 31.

As shown in Fig. 3(b), nitrogen-element-containing substance introduction valve 31 of reactor 51 is connected to nitrogen-element-containing substance supply line 32, group III-element-containing substance introduction valve 21 is connected to a group III-element-containing substance supply line 22, alkali-metal-element-containing substance introduction valve 11 is connected to an alkali-metal-element-containing substance supply line 12, and heater 53 is disposed around reactor 51. An inert gas within reactor 51 is removed through evacuation valve 43 by means of evacuation apparatus 44 such as a vacuum pump, and thereafter, nitrogen-element-containing substance supply container 34 is used to introduce N₂ gas into reactor 51 through nitrogen-element-containing substance introduction valve 31. Then, reactor 51 is heated by heater 53 so as to melt alkali-metal-element-containing substance 1 (such as Na) and group III-element-containing substance 2 (such as Ga), thereby forming group III-alkali melt 4 (such as a Ga-Na melt) containing the alkali metal element (such as Na) and the group III-element (such as Ga). Then, nitrogen-element-containing substance supply container 34 is used to introduce nitrogen-element-containing substance 3 such as N₂ gas into reactor 51 through nitrogen-element-containing substance introduction valve 31.

As shown in Figs. 3(b) and 3(c), N₂ gas representing nitrogen-element-containing substance 3 that has been introduced into reactor 51 is dissolved in group III-alkali melt 4, so as to form melt 5 containing the alkali metal element (such as Na), the group III-element (such as Ga) and the nitrogen element (N).

As shown in Fig. 3(d), a prescribed pressure and temperature of reactor 51 are set by controlling thermal output of heater 53 and by regulating nitrogen-element-containing substance introduction valve 31, nitrogen-element-containing substance supply valve 33 and evacuation valve 43, so as to grow GaN crystal representing group III-nitride crystal 6 from melt 5. Here, as the composition of the alkali metal element, the group III-element and the nitrogen element in melt 5 changes with growth of group III-nitride crystal 6, crystal growth is inhibited.

In contrast, as shown in Fig. 3(d), N₂ gas representing nitrogen-element-containing substance 3 is introduced into reactor 51 from nitrogen-element-containing substance supply container 34 through nitrogen element supply valve 33, nitrogen-element-containing substance supply line 32 and nitrogen-element-containing substance introduction valve 31. In addition, after an atmosphere remaining in group III-element-containing substance supply line 22 is removed by means of evacuation apparatus 44 through an evacuation valve 42, liquid metal Ga representing group III-element-containing substance 2 is introduced into crystal growth container 52 within reactor 1 from a group III-element-containing substance supply container 24 through group III-element-containing substance supply valve 23, group III-element-containing substance supply line 22 and group III-element-containing substance introduction valve 21. Moreover, after an atmosphere remaining in alkali-metal-element-containing substance supply line 12 is removed by means of evacuation apparatus 44 through an evacuation valve 41, liquid metal Na representing alkali-metal-element-containing substance 1 is introduced into crystal growth container 52 within reactor 51 from an alkali-metal-element-containing substance supply container 14 through alkali-metal-element-containing substance supply valve 13, alkali-metal-element-containing substance supply line 12 and alkali-metal-element-containing substance introduction valve 11.

As described above, in the step of growing the group III-nitride crystal, at least one of the alkali-metal-element-containing substance, the group III-element-containing substance and the nitrogen-element-containing substance is introduced into the reactor as appropriate or continuously, so that the group III-nitride crystal can grow for a long time with a composition ratio of the alkali-metal-element-containing substance, the group III-element-containing substance and the nitrogen-element-containing substance being maintained constant. Therefore, the group III-nitride crystal substrate attaining low oxygen concentration, a small absorption coefficient, and a large size can be obtained.

When the alkali metal element is accommodated in the alkali-metal-element-containing substance supply container as well, from the viewpoint of prevention of oxidation of the alkali-metal-element-containing substance, the alkali-metal-element-containing substance is preferably handled in the drying container in which a moisture concentration is controlled to at most 1.0ppm (dew point: -76°C) and preferably to at most 0.54ppm (dew point: -80°C). For example, referring to Fig. 4, as shown in Fig. 4(a), metal Na representing alkali-metal-element-containing substance 1 is accommodated in an alkali-metal-element-containing substance supply container main body 14a in drying container 100. Then, alkali-metal-element-containing substance supply container main body 14a is sealed by an alkali-metal-element-containing substance supply container cover 14b and taken out of drying container 100. Thereafter, alkali-metal-element-containing substance supply container 14 is heated by a heater, so as to obtain liquid metal Na serving as alkali-metal-element-containing substance 1.

Referring to Fig. 5, a method of controlling a moisture concentration (or a method of controlling a dew point) in drying container 100 used in Embodiments 1 to 5 above will now be described. Drying container 100 is formed by a main container 100a and a side container 100b. Gloves 106 are provided in armholes 105 of main container 100a, so that an operation within main container 100a of drying container 100 can be performed by inserting hands in gloves 106.

Referring to Fig. 5, in main container 100a or side container 100b, a vacuum pump 131, a main evacuation valve 133 and a side evacuation valve 143 for evacuating main container 100a and/or side container 100b are disposed, and an inert gas supply container 121, an inert gas supply source valve 122, an inert gas main supply valve 123, and an inert gas side supply valve 124 for supplying an inert gas to main container 100a and/or side container 100b are disposed. In addition, a blower 111, a cooling tower 112, a cooler 113, a dehydration/deoxidation tower 114, a circulation valve 115, a moisture meter 102, and an oximeter 103 for attaining, maintaining and controlling the moisture concentration to at most 1.0ppm (dew point: -76°C) and preferably to at most 0.54ppm (dew point: -80°C) are provided in main container 100a. Here, cooling tower 112 is cooled by cooler 113, and dehydration/deoxidation tower 114 is filled with a dehydrator such as molecular sieve and a deoxidizer such as reduced copper.

In order to lower the moisture concentration in main container 100a and in side container 100b of drying container 100, main container 100a and side container 100b are evacuated by means of vacuum pump 131. Thereafter, Ar gas or N₂ gas serving as the inert gas is introduced from inert gas supply container 121. In addition, in order to control the moisture concentration in main container 100a of drying container 100 to at most 1.0ppm (dew point: -76°C) and preferably to at most 0.54ppm (dew point: -80°C), the inert gas that fills main container 100a is circulated sequentially from blower 111 then to cooling tower 112, dehydration/deoxidation tower 114 and to main container 100a, while measuring the moisture concentration and the oxygen concentration within main container 100a using moisture meter 102 and oximeter 103 provided in main container 100a. The inert gas circulated as described above serves for dehydration and deoxidation when it passes through dehydration/deoxidation tower 114. Therefore, by regulating an amount of circulated inert gas and by setting a cooling temperature in the cooling tower to at most 0°C, the moisture concentration in main container 100a can be controlled to at most 1.0ppm and preferably to at most 0.54ppm also during an operation which will be described below.

In handling the alkali-metal-element-containing substance or the like in drying container 100, for example, the reactor and a container for storage of the alkali-metal-element-containing substance are first placed in side container 100b. Side container 100b is then evacuated and thereafter filled with an inert gas such as Ar gas or N₂ gas. Then, a partition between the side container and the main container is removed, so that the reactor and the container for storage of the alkali-metal-element-containing substance are moved from the side container to the main container. The reactor and the container for storage of the alkali-metal-element-containing substance are opened in the main container in which the moisture concentration is controlled, the alkali-metal-element-containing substance or the like is accommodated in the reactor, and the reactor is sealed. After the sealed reactor is moved to the side container, it is taken out of drying container 100. As a result of such handling, the alkali-metal-element-containing substance can be introduced into the reactor without being oxidized, while the moisture concentration in the main container is controlled to at most 1.0ppm (dew point: -76°C) and preferably to at most 0.54ppm (dew point: -80°C).

### (Embodiment 6)

The present embodiment is directed to a group III-nitride semiconductor device having at least one group III-nitride layer formed on the group III-nitride crystal substrate obtained in Embodiments 1 to 5. Referring to Fig. 6, the semiconductor device according to the present embodiment implements an LED, in which an n-type GaN layer 61, a multiple quantum well structure 62 implemented by stacking one or more pair of an In_{0.15}Ga_{0.85}N layer and a GaN layer, a p-type Al_{0.20}Ga_{0.80}N layer 63, and a p-type GaN layer 64 as the group III-nitride crystal layer are successively formed on a GaN substrate 60 serving as the group III-nitride crystal substrate with MOCVD (Metal Organic Chemical Vapor Deposition), an n-side electrode 66 is formed under the GaN substrate, and a p-side electrode 65 is formed on p-type GaN layer 64. As the LED in the present embodiment employs the group III-nitride substrate that attains low oxygen concentration and small absorption coefficient, its light emission intensity is high.

From the viewpoint of improvement in light emission intensity of the LED, the group III-nitride crystal substrate according to the present invention obtained in Embodiments 1 to 5 preferably attains an absorption coefficient, in a wavelength range from 400nm to 600nm, of at most 40cm⁻¹ and preferably of at most 20cm⁻¹. In addition, from the viewpoint of improvement in light emission intensity of the LED, the group III-nitride crystal substrate according to the present invention attains an oxygen concentration of at most 1 × 10¹⁷/cm³, preferably of at most 5× 10¹⁶/cm³, and more preferably of at most 2 x 10¹⁶/cm³.

### Examples

### (Example 1)

The present example corresponds to Embodiment 2 above. Referring to Fig. 2, as shown in Fig. 2(a), in drying container 100 in which a moisture concentration was controlled to 0.09ppm to 0.54ppm (dew point: -90°C to -80°C) and the oxygen concentration was controlled to 0.3ppm to 0.8ppm, 10g of metal Na (purity 99.95%) representing alkali-metal-element-containing substance 1 and 10g of metal Ga (purity 99.9999%) representing group III-element-containing substance 2 were accommodated, along with 170mg GaN seed crystal serving as the seed crystal, in crystal growth container (crucible) 52 (a mol percent in composition of metal Ga and metal Na was set to 25% and 75%, respectively). Here, crystal growth container 52 having a diameter of 1.9cm and a height of 8cm and made of Al₂O₃ (purity 99.99%) was provided in reactor 51 having a diameter of 2.5cm and a height of 10cm and made of SUS.

As shown in Fig. 2(b), nitrogen-element-containing substance introduction valve 31 of reactor 51 was connected to nitrogen-element-containing substance supply line 32, and heater 53 was disposed around reactor 51. N₂ gas (purity 99.9999%) representing nitrogen-element-containing substance 3 was introduced into reactor 51 from nitrogen-element-containing substance supply container 34 through nitrogen-element-containing substance supply valve 33 and nitrogen-element-containing substance introduction valve 31. Then, reactor 51 was heated by heater 53, so as to form a Ga-Na melt representing group III-alkali melt 4 (the liquid temperature at the surface of the melt was set to 780°C). Here, nitrogen-element-containing substance supply valve 33 and nitrogen-element-containing substance introduction valve 31 were regulated such that a gas partial pressure of N₂ gas attained to 50 atmospheric pressure (5.065MPa).

As shown in Fig. 2(c), N₂ gas was dissolved in the Ga-Na melt, to form melt 5 containing the alkali metal element (Na), the group III-element (Ga) and the nitrogen element (N) (the liquid temperature at the surface of the melt was set to 780°C). As shown in Fig. 2(d), GaN crystal representing group III-nitride crystal 6 was grown from melt 5. Here, heaters 53a, 53b were controlled such that the growth temperature of the GaN crystal (that is, the temperature at an interface between melt 5 and group III-nitride crystal 6) was set to 750°C.

The GaN crystal was taken out from reactor 51, followed by cutting and surface polishing. Then, the GaN crystal substrate having a size of 10mm×10mm×300µm thickness was obtained. The GaN crystal substrate attained the maximum absorption coefficient, in a wavelength range from 400nm to 600nm, of 30cm⁻¹, and attained the oxygen concentration of 5×10¹⁶/cm³. The absorption coefficient was measured using a spectrophotometer, while the oxygen concentration was measured by SIMS (Secondary Ion Mass Spectroscopy).

Referring to Fig. 6, an LED device was obtained by successively forming n-type GaN layer 61 having a thickness of 2µm, multiple quantum well structure 62 implemented by stacking three pairs of the In_{0.15}Ga_{0.80}N layer having a thickness of 3nm and the GaN layer having a thickness of 15nm, p-type Al_{0.20}Ga_{0.80}N layer 63 having a thickness of 20nm, and p-type GaN layer 64 having a thickness of 100nm on a (0001) surface (upper surface) of GaN crystal substrate 60 with MOCVD, by forming n-side electrode 66 having a diameter of 50µm in the center of a lower surface of the GaN substrate, and by forming p-side electrode 65 on the upper surface of p-type GaN layer 64. Here, Si was selected as an n-type dopant, while Mg was selected as a p-type dopant. Relative light emission intensity when a current of 20mA was fed to these electrodes of the LED device attained to 3.7, as compared with 1.0 attained by the LED device according to Comparative Example 1 which will be described later. Light emission intensity of the LED device was measured using a spectrophotometer. The result is summarized in Table 1.

### (Example 2)

The present example corresponds to Embodiment 2 above. Referring to Fig. 2(a), the GaN crystal substrate was obtained as in Example 1, except that the step of introducing alkali-metal-element-containing substance 1 (metal Na) and group III-element-containing substance 2 (metal Ga) into crystal growth container 52 provided in reactor 51 was performed in drying container 100 in which the moisture concentration was controlled to 0.54ppm to 1.0ppm (dew point: -80°C to -76°C) and the oxygen concentration was controlled to 0.3ppm to 0.5ppm. The obtained GaN crystal substrate attained the maximum absorption coefficient, in a wavelength range from 400nm to 600nm, of 40cm⁻¹, and attained the oxygen concentration of 8×10¹⁶/cm³. In addition, the GaN crystal substrate was used to fabricate the LED device, as in Example 1. The obtained LED device attained the relative light emission intensity of 2.1. The result is summarized in Table 1.

### (Example 3 not falling within the scope of the claims)

The present example corresponds to Embodiment 3 above. The GaN crystal substrate was obtained as in Example 1, except that the step of introducing alkali-metal-element-containing substance 1 (metal Na) and group III-element-containing substance 2 (metal Ga) into crystal growth container 52 provided in reactor 51 was performed in drying container 100 in which the moisture concentration was controlled to 1.0ppm to 2.6ppm (dew point: -76°C to -70°C) and the oxygen concentration was controlled to 0.3ppm to 0.5ppm as shown in Fig. 2(a), and except that the liquid temperature at the surface of the melt was set to 880°C and the growth temperature of the GaN crystal was set to 850°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm, of 30cm⁻¹, and attained the oxygen concentration of 5×10¹⁶/cm³. In addition, the GaN crystal substrate was used to fabricate the LED device, as in Example 1. The obtained LED device attained the relative light emission intensity of 3.7. The result is summarized in Table 1.

### (Example 4 not falling within the scope of the claims)

The present example also corresponds to Embodiment 3. The GaN crystal substrate was obtained as in Example 3, except that the liquid temperature at the surface of the melt was set to 910°C and the growth temperature of the GaN crystal was set to 880°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm, of 30cm⁻¹, and attained the oxygen concentration of 5×10¹⁶/cm³. In addition, the GaN crystal substrate was used to fabricate the LED device, as in Example 1. The obtained LED device attained the relative light emission intensity of 3.7. The result is summarized in Table 1.

### (Example 5)

The present example corresponds to Embodiment 4. The GaN crystal substrate was obtained as in Example 1, except that the liquid temperature at the surface of the melt was set to 880°C and the growth temperature of the GaN crystal was set to 850°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm of 20cm⁻¹, and attained the oxygen concentration of 2x 10¹⁶/cm³. In addition, the GaN crystal substrate was used to fabricate the LED device, as in Example 1. The obtained LED device attained the relative light emission intensity of 8.5. The result is summarized in Table 1.

### (Example 6)

The present example also corresponds to Embodiment 4. The GaN crystal substrate was obtained as in Example 1, except that the liquid temperature at the surface of the melt was set to 910°C and the growth temperature of the GaN crystal was set to 880°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm, of 18cm⁻¹, and attained the oxygen concentration of 2x 10¹⁶/cm³. In addition, the GaN crystal substrate was used to fabricate the LED device, as in Example 1. The obtained LED device attained the relative light emission intensity of 8.9. The result is summarized in Table 1.

### (Example 7)

The present example also corresponds to Embodiment 4. The GaN crystal substrate was obtained as in Example 1, except that the liquid temperature at the surface of the melt was set to 910°C and the growth temperature of the GaN crystal was set to 910°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm, of 12cm⁻¹, and attained the oxygen concentration of 1 × 10¹⁶/cm³. In addition, the GaN crystal substrate was used to fabricate the LED device, as in Example 1. The obtained LED device attained the relative light emission intensity of 15. The result is summarized in Table 1.

### (Comparative Example 1)

The GaN crystal substrate was obtained as in Example 3, except that the liquid temperature at the surface of the melt was set to 840°C and the growth temperature of the GaN crystal was set to 810°C in the step of growing group III-nitride crystal 6 (GaN crystal) from melt 5 as shown in Fig. 2(d). The obtained GaN crystal substrate attained the maximum absorption coefficient, in a wavelength range from 400nm to 600nm, of 120cm⁻¹, and attained the oxygen concentration of 1.5×10¹⁷/cm³. In addition, the GaN crystal substrate was used to fabricate the LED device, as in Example 1. As described above, the LED device obtained in this comparative example attained the relative light emission intensity of 1.0. The result is summarized in Table 1.

### (Example 8)

The present example also corresponds to Embodiment 4. According to the Examples 1 to 7 and Comparative Example 1 described above, alkali-metal-element-containing substance 1 (metal Na) and group III-element-containing substance 2 (metal Ga) were introduced into reactor 51 to obtain group III-alkali melt 4, and thereafter the nitrogen-element-containing substance (N₂ gas) was dissolved in group III-alkali melt 4 to form melt 5, as shown in Fig. 2. On the other hand, the present embodiment is different from the former in that metal Na representing alkali-metal-element-containing substance 1 and NaN₃ representing group III-element-containing substance 2 and nitrogen-element-containing substance 3 were introduced into reactor 51 and melted to form melt 5, as shown in Fig. 1.

Namely, according to the present example, referring to Fig. 1, as shown in Fig. 1(a), in drying container 100 in which the moisture concentration was controlled to 0.09ppm to 0.54ppm (dew point: -90°C to -80°C) and the oxygen concentration was controlled to 0.4ppm to 0.9ppm, 28.3g of NaN₃ representing alkali-metal-element-containing substance 1 and nitrogen-element-containing substance 3 and 10g of metal Ga representing group III-element-containing substance 2 were accommodated, along with 170mg of GaN seed crystal serving as the seed crystal, in crystal growth container (crucible) 52 (a mol percent in composition of metal Ga and metal Na was set to 25% and 75%, respectively). Here, crystal growth container 52 having a diameter of 1.9cm and a height of 20cm and made of Al₂O₃ was provided in reactor 51 having a diameter of 2.5cm and a height of 21cm and made of SUS.

As shown in Fig. 1(b), nitrogen-element-containing substance introduction valve 31 of reactor 51 was connected to nitrogen-element-containing substance supply line 32, and heater 53 was disposed around reactor 51. Then, reactor 51 was heated by heater 53 so as to form melt 5 containing the alkali metal element (Na), the group III-element (Ga) and the nitrogen element (N) (the liquid temperature at the surface of the melt was set to 880°C). Here, the pressure in reactor 51 was controlled to 50 atmospheric pressure (5.065MPa) by partially discharging N₂ gas, that was produced as a result of decomposition of NaN₃, to evacuation apparatus 44 through evacuation valve 43.

As shown in Fig. 1(c), GaN crystal representing group III-nitride crystal 6 was grown from melt 5. Here, heaters 53a, 53b were controlled such that the growth temperature of the GaN crystal (that is, the temperature at an interface between melt 5 and group III-nitride crystal 6) was set to 850°C.

The GaN crystal was taken out from reactor 51, followed by cutting and surface polishing. Then, the GaN crystal substrate having a size of 6mm×8mm×300µm thickness was obtained. The GaN crystal substrate attained the maximum absorption coefficient, in a wavelength range from 400nm to 600nm, of 20cm⁻¹, and attained the oxygen concentration of 2×10¹⁶/cm³.

In addition, the GaN crystal substrate was used to fabricate the LED device, as in Example 1. The obtained LED device attained the relative light emission intensity of 8.5. The result is summarized in Table 1.

**Table 1**

| | | | Example 1 | Example 2 | Example 3 | Example 4 | Example 5 | Example 6 | Example 7 | Example 8 | Comparative Example 1 |
|---|---|---|---|---|---|---|---|---|---|---|---|
| | | Group III-element-containing substance (g) | Ga (10) | Ga (10) | Ga (10) | Ga (10) | Ga (10) | Ga (10) | Ga (10) | Ga (10) | Ga (10) |
| | | Alkali-metal-element-containing substance (g) | Na (10) | Na (10) | Na (10) | Na (10) | Na (10) | Na (10) | Na (10) | NaN₃ (28.3) | Na (10) |
| | | Nitrogen-element-containing substance (gas partial pressure MPa) or (g) | N₂ (5.065) | N₂ (5.065) | N₂ (5.065) | N₂ (5.065) | N₂ (5.065) | N₂ (5.065) | N₂ (5.065) | | N₂ (5.065) |
| | Condition for manufacturing | Moisture concentration in drying container (ppm) | 0.09 to 0.54 | 0.54 to 1.0 | 1.0 to 2.6 | 1.0 to 2.6 | 0.09 to 0.54 | 0.09 to 0.54 | 0.09 to 0,54 | 0.09 to 0.54 | 1.0 to 2.6 |
| Group III-nitride crystal substrate | | Dew point in drying container (°C) | -90 to -80 | -80 to -76 | -76 to -70 | -76 to -70 | -90 to -80 | -90 to -80 | -90 to -80 | -90 to -80 | -76 to -70 |
| | | Temperature at the surface of melt (°C) | 780 | 780 | 880 | 910 | 880 | 910 | 910 | 880 | 840 |
| | | Growth temperature of group III-nitride crystal (°C) | 750 | 750 | 850 | 880 | 850 | 880 | 910 | 850 | 810 |
| | Physical property | Maximum absorption coefficient in wavelength range from 400nm to 600nm (cm⁻¹) | 30 | 40 | 30 | 30 | 20 | 18 | 12 | 20 | 120 |
| | | Oxygen concentration (count/cm³) | 5×10¹⁶ | 8×10¹⁶ | 5×10¹⁶ | 5×10¹⁶ | 2×10¹⁶ | 2×10¹⁶ | 1×10¹⁶ | 2×10¹⁶ | 1.5×10¹⁷ |
| Relative light emission intensity of LED | | | 3.7 | 2.1 | 3.7 | 3.7 | 8.5 | 8.9 | 15 | 8.5 | 1.0 |

As can clearly be seen from Table 1, the group III-nitride crystal substrate that attains the absorption coefficient, in a wavelength range from 400nm to 600nm, of at most 40cm⁻¹ and attains the oxygen concentration of at most 5 × 10¹⁶/cm³ was obtained, by handling the alkali-metal-element-containing substance in the drying container in which the moisture concentration was controlled to at most 1.0ppm (dew point: -76°C) and preferably to at most 0.54ppm (dew point: -80°C) in the step of introducing the alkali-metal-element-containing substance in the reactor (Examples 1, 2) or by setting a crystal growth temperature to at least 850°C in the step of growing the group III-nitride crystal from the melt containing at least the alkali metal element, the group III-element and the nitrogen element (Examples 3, 4). The relative light emission intensity of the LED device employing the group III-nitride crystal substrate was improved to at least 2.1.

In addition, the group III-nitride crystal substrate that attains the absorption coefficient, in a wavelength range from 400nm to 600nm, of at most 20cm⁻¹ and attains the oxygen concentration of at most 2×10¹⁶/cm³ was obtained, by handling the alkali-metal-element-containing substance in the drying container in which the moisture concentration was controlled to at most 0.54ppm (dew point: -80°C) in the step of introducing the alkali-metal-element-containing substance in the reactor and by setting a crystal growth temperature to at least 850°C in the step of growing the group III-nitride crystal from the meh containing at least the alkali metal element, the group III-element and the nitrogen element (Example 5 to 8). The relative light emission intensity of the LED device employing the group III-nitride crystal substrate was improved to at least 8.5.

The embodiments and examples disclosed above are by way of illustration and are not to be taken by way of limitation, the spirit and scope of the present invention being limited not by the embodiments and examples above but by the claims and intended to include all modifications and variations within the scope of the claims.

### Industrial Applicability

As described above, the present invention can widely be utilized in a group III-nitride crystal substrate attaining a small absorption coefficient and a method of manufacturing the same as well as in a group III-nitride semiconductor device.

## Claims

1. A method of manufacturing a group III-nitride crystal substrate in which group III-nitride crystal (6) grows from a melt (5) containing an alkali metal element, a group III-element and a nitrogen element, comprising the steps of:
introducing an alkali-metal-element-containing substance (1) containing said alkali metal element, a group III-element-containing substance (2) containing said group III-element, and a nitrogen-element-containing substance (3) containing said nitrogen element into a reactor (51);
forming the melt (5) containing at least said alkali metal element, said group III-element and said nitrogen element in said reactor; and
growing the group III-nitride crystal (6) from said melt (5); wherein
at least in said step of introducing said alkali-metal-element-containing substance (1) into said reactor (51), said alkali-metal-element-containing substance (1) is handled in a drying container (100) in which a moisture concentration is controlled to at most 1.0ppm.

2. The method of manufacturing a group III-nitride crystal substrate according to claim 1, wherein
at least in said step of introducing said alkali-metal-element-containing substance (1) into said reactor (51), said alkali-metal-element-containing substance (1) is handled in the drying container (100) in which a moisture concentration is controlled to at most 0.54ppm.

3. The method of manufacturing a group III-nitride crystal substrate according to claim 1, wherein
said step of introducing said alkali-metal-element-containing substance (1), said group III-element-containing substance (2) and said nitrogen-element-containing substance (3) into said reactor (51) includes the steps of introducing said alkali-metal-element-containing substance (1) and said group III-element-containing substance (2) into said reactor (51), forming a group III-alkali melt (4) containing at least said alkali metal element and said group III-element in said reactor (51), and introducing said nitrogen-containing substance (3) into said group III-alkali melt (4), and
said step of forming the melt (5) containing at least said alkali metal element, said group III-element and said nitrogen element in said reactor (51) includes the step of dissolving the nitrogen-element-containing substance (3) in said group III-alkali melt (4).

4. The method of manufacturing a group III-nitride crystal substrate according to claim 1, wherein
said step of growing the group III-nitride crystal (6) from said melt (5) further includes the step of introducing at least one of said alkali-metal-element-containing substance (1), said group III-element-containing substance (2) and said nitrogen-element-containing substance (3) into said reactor (51).

5. The method of manufacturing a group III-nitride crystal substrate according to claim 1, wherein in said step of growing said group III-nitride crystal (6) from said melt (5), a growth temperature of said group III-nitride crystal (6) is set to at least 850 °C.

6. The method of manufacturing a group III-nitride crystal substrate according to claim 5, wherein
said step of introducing said alkali-metal-element-containing substance (1), said group III-element-containing substance (2) and said nitrogen-element-containing substance (3) into said reactor (51) includes the steps of introducing said alkali-metal-element-containing substance (1) and said group III-element-containing substance (2) into said reactor (51), forming a group III-alkali melt (4) containing at least said alkali metal element and said group III-elementin said reactor (51), and introducing said nitrogen-containing substance (5) into said group III-alkali melt (4), and
said step of forming the melt (5) containing at least said alkali metal element (1), said group III-element(2) and said nitrogen element (3) in said reactor (51) includes the step of dissolving the nitrogen-element-containing substance (3) in said group III-alkali melt (4).

7. The method of manufacturing a group III-nitride crystal substrate according to claim 5, wherein
said step of growing the group III-nitride crystal (6) from said melt (5) further includes the step of introducing at least one of said alkali-metal-element-containing substance (1), said group III-element-containing substance (2) and said nitrogen-element-containing substance (3) into said reactor (51).

8. A group III-nitride crystal substrate attaining an oxygen concentration of at most 1×10¹⁷ /cm³ and an absorption coefficient, in a wavelength range from 400nm to 600nm, of at most 40cm⁻¹.

9. A group III-nitride semiconductor device, wherein
at least one group III-nitride crystal layer is formed on the group III-nitride crystal substrate according to claim 8.

## Patentansprüche

1. Verfahren zur Herstellung eines Gruppe III Nitridkristallsubstrats, bei dem ein Gruppe III Nitridkristall (6) aus einer Schmelze (5), die ein Alkalimetallelement, eine Gruppe III Element und ein Stickstoffelement enthält, wächst, wobei das Verfahren folgende Schritte umfasst:
Einführen einer Alkalimetallelement enthaltenden Substanz (1), die das Alkalimetallelement enthält, einer Gruppe-III-Element enthaltenden Substanz (2), die das Gruppe-III-Element enthält, und eine Stickstoffelement enthaltende Substanz (3), die das Stickstoffelement enthält, in einen Reaktor (51);
Bilden der Schmelze (5), die zumindest das Alkalimetallelement, das Gruppe III Element und das Stickstoffelement enthält, in dem Reaktor; und
Wachsen des Gruppe III Nitridkristalls (6) aus der Schmelze (5); wobei zumindest in dem Schritt des Einführens der Alkalimetallelement enthaltenden Substanz (1) in den Reaktor (51) die Alkalimetallelement enthaltende Substanz (1) in einem Trocknungsbehälter (100) gehandhabt wird, in dem eine Feuchtigkeitskonzentration auf höchstens 1,0 ppm eingestellt wird.

2. Verfahren zur Herstellung eines Gruppe III Nitridkristallsubstrats nach Anspruch 1, wobei zumindest in dem Schritt des Einführens der Alkalimetallelement enthaltenden Substanz (1) in den Reaktor (51) die Alkalimetallelement enthaltende Substanz (1) in dem Trocknungsbehälter (100) gehandhabt wird, in dem eine Feuchtigkeitskonzentration auf höchstens 0,54 ppm eingestellt ist.

3. Verfahren zur Herstellung eines Gruppe III Nitridkristallsubstrats nach Anspruch 1, worin der Schritt des Einführens der Alkalimetallelement enthaltenden Substanz (1), der Gruppe-III-Element enthaltenden Substanz (2) und der Stickstoffelement enthaltenden Substanz (3) in den Reaktor (51) die Schritte des Einführens der Alkalimetallelement enthaltenden Substanz (1) und der Gruppe-III-Element enthaltenden Substanz (2) in den Reaktor (51), des Bildens einer Gruppe III Alkalischmelze (4), die zumindest das Alkalimetallelement und das Gruppe-III-Element enthält, in dem Reaktor (51) und des Einführens der Stickstoff enthaltenden Substanz (3) in die Gruppe III Alkalischmelze (4) einschließt, und
wobei der Schritt des Bildens der Schmelze (5), die zumindest das Alkalimetallelement, das Gruppe III Element und das Stickstoffelement in dem Reaktor (51) enthält, den Schritt des Auflösens der Stickstoffelement enthaltenden Substanz (3) in der Gruppe III Alkalischmelze (4) einschließt.

4. Verfahren zur Herstellung eines Gruppe III Nitridkristallsubstrats nach Anspruch 1, worin der Schritt des Wachsens des Gruppe III Nitridkristalls (6) aus der Schmelze (5) weiterhin den Schritt des Einführens der Alkalimetallelement enthaltenden Substanz (1) und/oder der Gruppe-III-Element enthaltenden Substanz (2) und/oder die Stickstoffelement enthaltende Substanz (3) in den Reaktor (51) einschließt.

5. Verfahren zur Herstellung eines Gruppe III Nitridkristallsubstrats nach Anspruch 1, worin in dem Schritt des Wachsens des Gruppe III Nitridkristalls (6) aus der Schmelze (5) eine Wachstumstemperatur des Gruppe III Nitridkristalls (6) auf mindestens 850 °C eingestellt ist.

6. Verfahren zur Herstellung eines Gruppe III Nitridkristallsubstrats nach Anspruch 5, worin
der Schritt des Einführens der Alkalimetallelement enthaltenden Substanz (1), der Gruppe III Element enthaltenden Substanz (2) und der Stickstoffelement enthaltenden Substanz (3) in den Reaktor (51) folgende Schritte einschließt:
Einführen der Alkalimetallelement enthaltenden Substanz (1), und der Gruppe-III-Element enthaltenden Substanz (2) in den Reaktor (51), Bilden einer Gruppe III Alkalischmelze (4), die zumindest das Alkalimetallelement und das Gruppe III Element enthält, in dem Reaktor (51), und Einführen der Stickstoff enthaltenden Substanz (5) in die Gruppe III Alkalischmelze (4), und
der Schritt des Bildens der Schmelze (5), die zumindest das Alkalimetallelement (1), das Gruppe-III-Element (2) und das Stickstoffelement (3) in dem Reaktor (51) enthält, den Schritt des Lösens der Stickstoffelement enthaltenden Substanz (3) in der Gruppe III Alkalischmelze (4) einschließt.

7. Verfahren zur Herstellung eines Gruppe III Nitridkristallsubstrats nach Anspruch 5, worin der Schritt des Wachsen des Gruppe III Nitridkristalls (6) aus der Schmelze (5) weiterhin den Schritt des Einführens der Alkalimetallelement enthaltenden Substanz (1) und/oder der Gruppe-III-Element enthaltenden Substanz (2) und/oder der Stickstoffelement enthaltenden Substanz (3) in den Reaktor (51) einschließt.

8. Gruppe III Nitridkristallsubstrat, das eine Sauerstoffkonzentration von höchstens 1×10¹⁷ / cm³ und einen Absorptionskoeffizienten im Wellenlängenbereich von 400 nm bis 600 nm von höchstens 40 cm⁻¹ erreicht.

9. Gruppe III Nitridhalbleitervorrichtung, worin mindestens eine Gruppe III Nitridkristallschicht auf dem Gruppe III Nitridkristallsubstrat nach Anspruch 8 ausgebildet ist.

## Revendications

1. Procédé de fabrication d'un substrat de cristal de nitrure du groupe III dans lequel le cristal de nitrure du groupe III (6) croît à partir d'une matière fondue (5) contenant un élément métallique alcalin, un élément du groupe III et un élément azoté, comprenant les étapes de :
introduction d'une substance contenant un élément métallique alcalin (1) contenant ledit élément métallique alcalin, d'une substance contenant un élément du groupe III (2) contenant ledit élément du groupe III, et d'une substance contenant un élément azoté (3) contenant ledit élément azoté dans un réacteur (51) ;
formation de la matière fondue (5) contenant au moins ledit élément métallique alcalin, ledit élément du groupe III et ledit élément azoté dans ledit réacteur ; et
la croissance du cristal de nitrure du groupe III (6) à partir de ladite matière fondue (5) ; dans lequel
au moins dans ladite étape d'introduction de ladite substance contenant un élément métallique alcalin (1) dans ledit réacteur (51), ladite substance contenant un élément métallique alcalin (1) est manipulée dans un récipient de séchage (100) dans lequel la teneur en humidité est régulée à 1,0 ppm au plus.

2. Procédé de fabrication d'un substrat de cristal de nitrure du groupe III selon la revendication 1, dans lequel
au moins dans ladite étape d'introduction de ladite substance contenant un élément métallique alcalin (1) dans ledit réacteur (51), ladite substance contenant un élément métallique alcalin (1) est manipulée dans le récipient de séchage (100) dans lequel la teneur en humidité est régulée à 0,54 ppm au plus.

3. Procédé de fabrication d'un substrat de cristal de nitrure du groupe III selon la revendication 1, dans lequel
ladite étape d'introduction de ladite substance contenant un élément métallique alcalin (1), de ladite substance contenant un élément du groupe III (2) et de ladite substance contenant un élément azoté (3) dans ledit réacteur (51) inclut les étapes d'introduction de ladite substance contenant un élément métallique alcalin (1) et de ladite substance contenant un élément du groupe III (2) dans ledit réacteur (51), de formation d'une matière fondue de métaux du groupe III-alcalins (4) contenant au moins ledit élément métallique alcalin et ledit élément du groupe III dans ledit réacteur (51), et d'introduction de ladite substance contenant de l'azote (3) dans ladite matière fondue de métaux du groupe III-alcalins (4), et
ladite étape de formation de la matière fondue (5) contenant au moins ledit élément métallique alcalin, ledit élément du groupe III et ledit élément azoté dans ledit réacteur (51) inclut l'étape de dissolution de la substance contenant un élément azoté (3) dans ladite matière fondue de métaux du groupe III-alcalins (4).

4. Procédé de fabrication d'un substrat de cristal de nitrure du groupe III selon la revendication 1, dans lequel
ladite étape de croissance du cristal de nitrure du groupe III (6) à partir de ladite matière fondue (5) inclut en outre l'étape d'introduction d'au moins une substance parmi ladite substance contenant un élément métallique alcalin (1), ladite substance contenant un élément du groupe III (2) et ladite substance contenant un élément azoté (3) dans ledit réacteur (51).

5. Procédé de fabrication d'un substrat de cristal de nitrure du groupe III selon la revendication 1, dans lequel dans ladite étape de croissance dudit cristal de nitrure du groupe III (6) à partir de ladite matière fondue (5), une température de croissance dudit cristal de nitrure du groupe III (6) est réglée à au moins 850 °C.

6. Procédé de fabrication d'un substrat de cristal de nitrure du groupe III selon la revendication 5, dans lequel
ladite étape d'introduction de ladite substance contenant un élément métallique alcalin (1), de ladite substance contenant un élément du groupe III (2) et de ladite substance contenant un élément azoté (3) dans ledit réacteur (51) inclut les étapes d'introduction de ladite substance contenant un élément métallique alcalin (1) et de ladite substance contenant un élément du groupe III (2) dans ledit réacteur (51), de formation d'une matière fondue de métaux du groupe III-alcalins (4) contenant au moins ledit élément métallique alcalin et ledit élément du groupe III dans ledit réacteur (51), et d'introduction de ladite substance contenant de l'azote (5) dans ladite matière fondue de métaux du groupe III-alcalins (4), et
ladite étape de formation de la matière fondue (5) contenant au moins ledit élément métallique alcalin (1), ledit élément du groupe III (2) et ledit élément azoté (3) dans ledit réacteur (51) inclut l'étape de dissolution de la substance contenant un élément azoté (3) dans ladite matière fondue de métaux du groupe III-alcalins (4).

7. Procédé de fabrication d'un substrat de cristal de nitrure du groupe III selon la revendication 5, dans lequel
ladite étape de croissance du cristal de nitrure du groupe III (6) à partir de ladite matière fondue (5) inclut en outre l'étape d'introduction d'au moins une substance
parmi ladite substance contenant un élément métallique alcalin (1), ladite substance contenant un élément du groupe III (2) et ladite substance contenant un élément azoté (3) dans ledit réacteur (51).

8. Substrat de cristal de nitrure du groupe III, atteignant une concentration d'oxygène de 1 ×10¹⁷/cm³ au plus et un coefficient d'absorption, dans une gamme de longueurs d'onde de 400 nm à 600 nm, de 40 cm⁻¹ au plus.

9. Dispositif à semi-conducteurs à base de nitrure du groupe III, dans lequel au moins une couche de cristal de nitrure du groupe III est formée sur le substrat de cristal de nitrure du groupe III selon la revendication 8.
